(19) **Europäisches Patentamt European Patent Office Office européen des brevets**

(11) **EP 4 198 541 B1**

(12) **EUROPEAN PATENT SPECIFICATION**

(45) Date of publication and mention of the grant of the patent:
**11.02.2026 Bulletin 2026/07**

(21) Application number: **21315282.0**

(22) Date of filing: **17.12.2021**

(51) International Patent Classification (IPC):
**G01R 33/09** $^{(2006.01)}$ **H01F 10/32** $^{(2006.01)}$
**G01R 33/00** $^{(2006.01)}$

(52) Cooperative Patent Classification (CPC):
**G01R 33/098; G01R 33/0052; H01F 10/1936;
H01F 10/3236; H01F 10/3254; H01F 10/3272;
H01F 10/3286**

(54) **MAGNETORESISTIVE ELEMENT HAVING HIGH OUT-OF-PLANE SENSITIVITY**

MAGNETORESISTIVES ELEMENT MIT HOHER EMPFINDLICHKEIT AUSSERHALB DER EBENE

ÉLÉMENT MAGNÉTORÉSISTIF DOTÉ D'UNE HAUTE SENSIBILITÉ HORS PLAN

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**21.06.2023 Bulletin 2023/25**

(73) Proprietor: **Allegro MicroSystems, LLC
Manchester, NH 03103 (US)**

(72) Inventors:
• **Strelkov, Nikita
  38240 Meylan (FR)**

• **Timopheev, Andrey
  38450 Vif (FR)**
• **Cuchet, Léa
  38430 Moirans (FR)**

(74) Representative: **South, Nicholas Geoffrey
Venner Shipley LLP
200 Aldersgate
London EC1A 4HD (GB)**

(56) References cited:
**EP-A1- 2 320 489        EP-A1- 3 862 769
WO-A1-2013/180277**

Processed by Luminess, 75001 PARIS (FR)

## Description

### Technical domain

The present invention relates to a magnetoresistive element for a magnetic sensor destined to sense an external magnetic field. More particularly, the present invention relates to a magnetoresistive element comprising a sense layer and having high out-of-plane sensitivity. The present invention further relates to a magnetoresistive element for measuring an external magnetic field along an axis substantially perpendicular to the plane of the sense layer.

### Related art

A magnetoresistive element typically comprises a reference layer having a reference magnetization and a sense layer having a free sense magnetization. A tunnel barrier layer is sandwiched between the reference layer 21 and the sense layer.

Such a magnetoresistive element can be used to sense an out-of-plane component of an external magnetic field. For the magnetoresistive element to sense an external magnetic field with high out-of-plane sensitivity, it must have a high tunnel magnetoresistance (TMR) value, small size (diameter), a thick sense layer, and low sense magnetization.

Implementation of thick sensing layers (>100nm) leads to difficulties in the fabrication process of the magnetoresistive element. For example, the fabrication process may require long etch time, redeposition, shortening, etc. Those difficulties can be at least partially overcome by changing the layout of the sensor comprising several magnetoresistive elements. However, this leads to a reduction of magnetoresistive element density per sensor area.

Patent application EP20315489.3 (not yet published) by the present applicant discloses magnetoresistive element comprising a reference layer having a fixed reference magnetization, a sense layer having a free sense magnetization and a tunnel barrier layer. The magnetoresistive element is configured to measure an external magnetic field oriented substantially perpendicular to the plane of the layers. The reference magnetization is oriented substantially perpendicular to the plane of the reference layer. The sense magnetization comprising a vortex configuration in the absence of an external magnetic field. The vortex configuration is substantially parallel to the plane of the sense layer and has a vortex core magnetization direction along an out-of-plane axis substantially perpendicular to the plane of the sense layer. The sense layer thickness is greater than 50 nm.

Document EP2320489A1 discloses a spin valve element capable of performing multi-value recording, which includes a pair of ferromagnetic layers having different coercivities that sandwich an insulating layer or a non-magnetic layer, wherein the ferromagnetic layer having small coercivity has a substantially circular in-plane profile, and a plurality of island-shaped non-magnetic portions.

Document WO2013180277 discloses an oscillator provided with a function enabling high frequency oscillation, a high Q value, and high heat stability through the use of a magnetic-vortex structure and interlayer exchange coupling. The oscillator is provided with: a fixed layer comprising a magnetic body of fixed magnetization having a magnetic-vortex structure vertically magnetized in the center portion; a non-magnetic layer comprising a non-magnetic body laminated on the fixed layer; a free layer laminated on the nonmagnetic layer and having vertical magnetization rotatably moving in the planar direction, the free layer comprising a strongly magnetic body having a magnetic-vortex structure of circular or regularly polygonal planar configuration that is vertically magnetized in the center portion; and a current-supply unit for sending a current through the layers.

Document EP3862769 discloses a magnetoresistive sensor element comprising: a reference layer having a pinned reference magnetization, a sense layer having a free sense magnetization comprising a stable vortex configuration reversibly movable in accordance to an external magnetic field to be measured, and a tunnel barrier layer. The sense layer comprises a first ferromagnetic sense portion in contact with the tunnel barrier layer and a second ferromagnetic sense portion in contact with the first ferromagnetic sense portion. The second ferromagnetic sense portion comprises a dilution element in a proportion such that a temperature dependence of a magnetic susceptibility of the sense layer substantially compensates a temperature dependence of a tunnel magnetoresistance of the magnetoresistive sensor element.

### Summary

An aim of the present disclosure is to improve the sensitivity of a magnetoresistive element by introducing a perpendicular magnetic anisotropy (PMA) across the sense layer of the magnetoresistive element possessing a vortex configuration.

The present disclosure concerns a magnetoresistive element comprising a reference layer having a reference magnetization oriented out-of-plane; a sense layer having a sense magnetization comprising a vortex configuration stable under the presence of an external magnetic field, the sense magnetization being reversibly movable in a direction out-of-plane relative to the reference magnetization when the external magnetic field varies in a direction out-of-plane; and a tunnel barrier layer between the reference layer and the sense layer. The sense layer has a thickness smaller than 200 nm. The sense layer comprises a ferromagnetic material configured such that the sense magnetization is between 300 and 1400 emu/cm$^3$ and such that the sense layer has a perpendicular magnetic anisotropy field that is greater than 1 kOe (79.6x10$^3$ A/m).

The vortex configuration is conserved under presence of external field of any direction with the amplitude greater or equal to 2.5 kOe.

The magnetoresistive element can be used for measuring an external magnetic field oriented in a direction perpendicular to the out-of-plane direction, i.e., in a direction substantially perpendicular the plane of the sense layer.

The present disclosure further concerns a magnetoresistive sensor comprising a plurality of the magnetoresistive element. The magnetoresistive sensor can be arranged in a Wheatstone circuit. The magnetoresistive sensor has an out-of-plane sensitivity greater than 1 mVN/mT.

The disclosed magnetoresistive element overcomes the shortcomings and limitations of the known magnetoresistive elements while preserving high level of out-of-plane sensitivity.

These and other advantages will be apparent from the description that follows.

## Short description of the drawings

Exemplar embodiments of the invention are disclosed in the description and illustrated by the drawings in which:

Fig. 1 illustrates a magnetoresistive element comprising a sense layer, according to an embodiment;

Fig. 2 shows a magnetoresistive sensor comprising a plurality of the magnetoresistive element, according to an embodiment;

Fig. 3 reports the variation of the sense magnetization as a function of the magnetic field for a sense layer 84 nm in thickness;

Fig. 4 reports the variation of the sense magnetization as a function of the magnetic field for a sense layer 20 nm in thickness;

Fig. 5 shows a partial view of the sense layer, according to an embodiment;

Fig. 6 shows a partial view of the sense layer comprising an oxide insert, according to an embodiment;

Fig. 7 shows a partial view of the sense layer comprising an oxide insert, according to another embodiment;

Fig. 8 shows the sense layer, according to another embodiment;

Fig. 9 shows out-of-plane magnetization loops for several configuration of the sense layer; and

Fig. 10 shows a fit of the out-of-plane magnetization loops of Fig. 9 to determine the perpendicular magnetic anisotropy field.

## Examples of embodiments

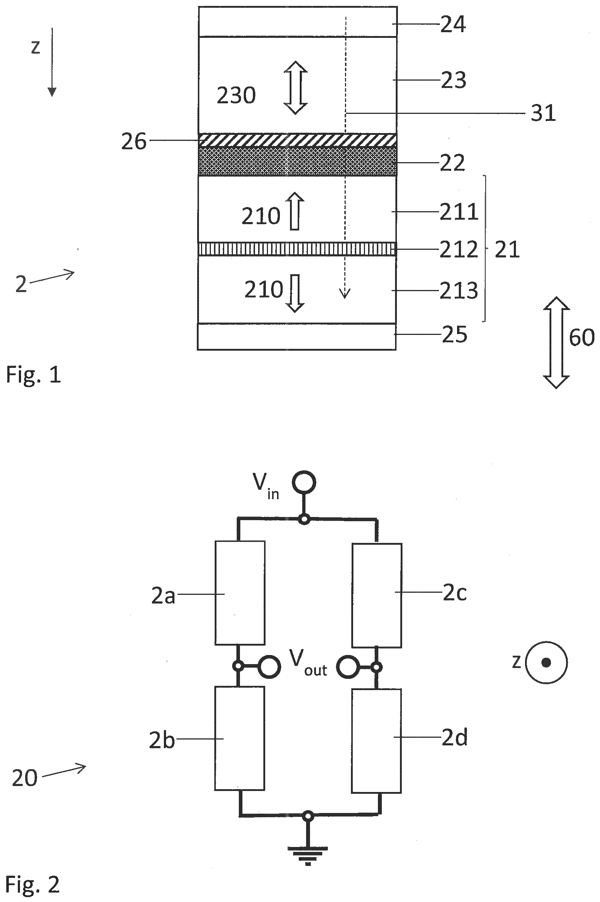

**Fig. 1,** illustrates a magnetoresistive element 2, according to an embodiment. The magnetoresistive element 2 comprises a reference layer 21 having a reference magnetization 210 and a sense layer 23 having a free sense magnetization 230. The magnetoresistive element 2 further comprises a tunnel barrier layer 22 between the reference layer 21 and the sense layer 23. The sense magnetization 230 can be freely oriented in an external magnetic field 60, in accordance with the direction of the external magnetic field 60, while the reference magnetizations 210 remain substantially undisturbed. The external magnetic field 60 can thus be sensed by measuring a resistance of the magnetoresistive sensor element 2. The magnetoresistive element 2 can further comprise an optional capping layer 24, 25 adjacent to the sense layer 23 and the reference layer 21, respectively.

The sense magnetization 230 comprises a stable vortex configuration stable under the presence of the external magnetic field 60. In one aspect, the sense magnetization 230 comprises a stable vortex configuration that is stable under the presence of the external magnetic field 60 having an amplitude equal or greater than 2.5 kOe (199x10$^3$ A/m). The vortex configuration provides a linear and non-hysteretic behavior in a large magnitude range of the external magnetic field 60, for practical size of the magnetoresistive element 2 and thickness of the sense layer 23.

The resistance of the magnetoresistive element 2 is determined by the averaged component of the sense magnetization 230 in a direction substantially perpendicular the plane of the sense layer 23 (along the direction denoted "z" in Fig. 1), relative to the orientation of the reference magnetization 210, when the external magnetic field 60 varies in a direction out-of-plane. Sensing the external magnetic field 60 can be performed by measuring an output voltage when passing a measuring current 31 through the magnetoresistive element 2. The vortex configuration is then advantageous for 1D magnetic sensor applications, especially for sensing an external magnetic field 60 oriented out-of-plane.

In one aspect, the reference magnetization 210 is oriented out-of-plane, i.e., perpendicular to the reference layer 21 (in the z direction).

The reference layer 21 can comprise, or can be made of, a ferromagnetic alloy such as CoFe, NiFe or CoFeB. The reference layer 21 can comprise one or a plurality of ferromagnetic layers or a synthetic antiferromagnet (SAF). The reference layer 21 can have a thickness between 2 nm and 4 nm, but preferably of about 4 nm.

As illustrated in Fig. 1, the reference layer 21 can comprise a synthetic anti-ferromagnet (SAF) configuration. For example, the reference layer 21 can comprises, in this order, a first reference layer 211 in contact with the tunnel barrier layer 22, a coupling layer 212, and second reference layer 13. The first reference layer 211 (soft reference layer) can comprise, or be made of, a soft ferromagnetic material such as CoFe or CoFeB. The second reference layer 213 can comprise, or be made of, a hard ferromagnetic material (hard reference layer). The hard ferromagnetic material can comprise a Co/Pt multilayer. The coupling layer 212 can be configured to provide a RKKY coupling. Each of the first and second reference layers 211, 213 has a reference magnetization 210 that is out-of-plane. Here, the stability of the reference magnetization 210 is achieved through coercivity and RKKY coupling.

For example, the reference layer 21 can comprise (Pt/Co)*n/Ru/(Pt/Co)*m/CoFeB, where the Pt/Co multilayer is repeated n times and the Pt/Co multilayer is repeated m times, and where n and m can vary between 1 and 20.

The tunnel barrier 22 can comprise an insulating material. Suitable insulating materials include oxides, such as aluminum oxide (e.g., $Al_2O_3$) and magnesium oxide (e.g., MgO). A thickness of the tunnel barrier layer 22 can be in the nm range, such as from about 1 nm to about 3 nm. In a preferred embodiment, the tunnel barrier layer 22 is MgO, for example formed by sputter depositing a MgO target, or by depositing one or more Mg layers and then oxidizing one or more Mg layers with a known radical oxidation (ROX) or natural oxidation (NOX) method. The interface of a MgO layer with a magnetic layer that is CoFeB, for example, provides higher interfacial perpendicular anisotropy and a greater magnitude of PMA in the magnetic layer than an interface with other metal oxides.

In an embodiment, the sense layer 23 has a thickness smaller than 200 nm, for example between 5 nm and 200 nm. Preferably, the sense layer 23 has a thickness between 5 nm and 50 nm, between 5 nm and 100 nm, or between 3nm and 30 nm.

The sense layer 23 comprises a ferromagnetic material configured such that the sense magnetization 230 is between 300 and 1400 emu/cm$^3$ and such that the sense layer 23 has a perpendicular magnetic anisotropy field $H_{PMA}$ that is greater than 1 kOe ($79.6 \times 10^3$ A/m). The so configured sense layer 23 allows for compensating the demagnetization field present in a thin sense layer (< 50 nm) and for increasing the sensitivity S of the magnetoresistive element 2 relative to a sense layer without PMA.

In an embodiment, the sense layer 23 comprises a soft ferromagnetic material and an enhancing material configured to enhance the perpendicular magnetic anisotropy field $H_{PMA}$. For example, soft ferromagnetic material can comprise a NiFe, CoFe, or a CoFeB alloy. The enhancing material enhances the PMA in sense layer 23 and increases the out-of-plane sensitivity S of the magnetoresistive element 2. The enhancing material allows for increasing the out-of-plane sensitivity S without increasing the thickness of the sense layer 23.

A magnetoresistive sensor for sensing a 1D external magnetic field 60 can comprise a plurality of the magnetoresistive element 2. In an embodiment illustrated in **Fig. 2,** the magnetoresistive sensor 20 is arranged in a Wheatstone full-bridge circuit. More particularly, the full-bridge circuit comprises two series connected magnetoresistive element 2a, 2b in parallel to two other series connected magnetoresistive element 2c, 2d. The reference magnetization 210 of the two upper magnetoresistive elements 2a, 2c can be oriented substantially in a direction opposed to the one of the two lower magnetoresistive elements 2b, 2d. The magnetoresistive sensor 20 forms a voltage divider. In the presence of the external magnetic field 60, an output voltage $V_{out}$ is measurable between the magnetoresistive elements 2a and 2b of the first half-bridge and between the magnetoresistive elements 2c and 2d of the second half-bridge. Other arrangements of the TMR sensing elements are possible, such as half-bridge.

The sense magnetization can be characterized by its susceptibility x, which corresponds to the slope of the linear region of the magnetization curve:

$$\chi = \partial M / \partial Bz \qquad (1)$$

where M is a unitless magnetization and Bz is a z component of external magnetic flux in Tesla (T) units.

In case of a Wheatstone bridge layout (such as the one shown in Fig. 2), the sensitivity S of the magnetoresistive element 2 can be derived as:

$$S = TMR/(2+TMR) \, \chi \qquad\qquad (2)$$

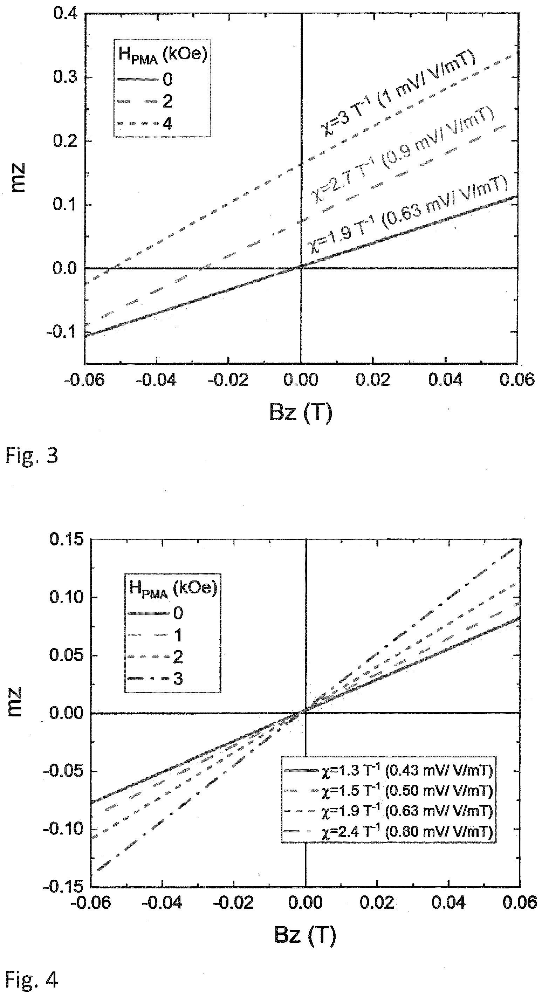

**Fig. 3** reports the variation of the sense magnetization 230 (mz in Fig. 3) as a function of the magnetic field Bz in the z direction, i.e., in the out-of-plane direction. Here, the sense layer 23 is 84 nm in thickness and comprises a ferromagnetic material having a perpendicular magnetic anisotropy field $H_{PMA}$ that varies from 0 to 4 kOe, resulting in an out-of-plane sensitivity S that varies from 1 mV/V/mT, for $H_{PMA}$ = 4 kOe ($318.4 \times 10^3$ A/m) to 0.9 mV/V/mT, for $H_{PMA}$ = 2 ($159.2 \times 10^3$ A/m) and to 0.63 mV/V/mT, for $H_{PMA}$ = 0 kOe. Here, the expression "out-of-plane sensitivity" signifies the change in output voltage $V_{out}$ of the magnetoresistive sensor 20 of Fig. 2 for a change in the external magnetic field 60 in the out-of-plane direction for each magnetoresistive element 2.

**Fig. 4** reports the variation of the sense magnetization 230 as a function of the magnetic field Bz for the sense layer 23 having a thickness of 20 nm and comprising a ferromagnetic material having a perpendicular magnetic anisotropy field $H_{PMA}$ that varies from 0 to 3 kOe ($0$ to $238.8 \times 10^3$ A/m). Here, the out-of-plane sensitivity S varies from 0.43 mV/V/mT to 0.8 mV/V/mT, respectively.

In both Figs 3 and 4, the sensitivity S is determined using equation (3) for full bridge sensitivity and assuming a TMR ratio of 100%, such that one obtains, in Fig. 3. a sensitivity S of 1 mV/V/mT for a susceptibility of 3 $T^{-1}$, a sensitivity S of 0.9 mV/V/mT for a susceptibility of 2.7 $T^{-1}$, and a sensitivity S of 0.63 mV/V/mT for a susceptibility of 1.9 $T^{-1}$, ad in Fig. 4, a sensitivity S of 0.8 mV/V/mT for a susceptibility of 2.4 $T^{-1}$, a sensitivity S of 0.63 mV/V/mT for a susceptibility of 1.9 $T^{-1}$, a sensitivity S of 0.5 mV/V/mT for a susceptibility of 1.5 $T^{-1}$, and a sensitivity S of 0.43 mVN/mT for a susceptibility of 1.3 $T^{-1}$.

In a thin sense layer 23, demagnetization field suppresses the out-of-plane component of magnetization and hence decreases the sensitivity S. The remanence of the sense magnetization 230 is also smaller for a thin sense layer 23 due to the higher demagnetizing field. In a thick sense layer 23, demagnetization field is smaller, and the sensitivity S is larger. Moreover, in a thin sense layer 23, the introduction of PMA allows compensating the demagnetizing field, such that similar sensitivity levels than that obtained in a thick sense layer without PMA can be achieved.

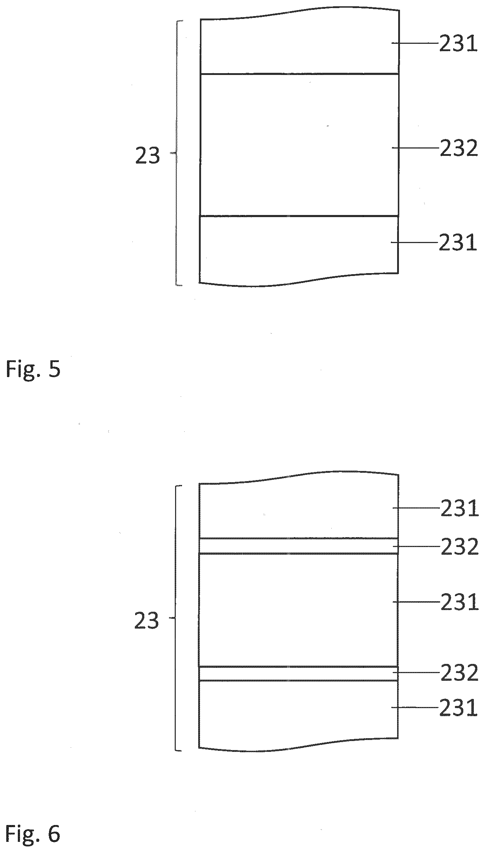

**Fig. 5** shows a partial view of the sense layer 23 comprising a first portion 231 comprising, or made of, the soft ferromagnetic material and a second portion 232 comprising, or made of, the enhancing material. The soft ferromagnetic material can comprise a NiFe, CoFe, or a CoFeB alloy.

Preferably, the magnetoresistive element 2 comprises an interface layer 26 (see Fig. 1) comprising, of made of, CoFeB, between the tunnel barrier layer 22 and the sense layer 23, in order to achieve a high **TMR** ratio (equal or above than 100%).

In one aspect, the enhancing material can comprise a laminate including any one of: $(Co/Pt)_n$, $(Co/Pd)_n$, $(Co/Au)_n$, $(Co/Fe)_n$, $(CoCr/Pt)_n$, $(NiFe/Cu)_n$, or $(Co/Cu)_n$, where n is the number of the multilayer and n is between about 10 and 100. The enhancing material can comprise other laminated stacks exhibiting intrinsic PMA where n is between 1 and 10. It should be understood that the aforementioned laminate may also be represented by $(Pt/Co)_n$, $(Pd/Co)_n$, $(Au/Co)_n$, $(Fe/Co)_n$, $(Pt/CoCr)_n$, $(Cu/NiFe)_n$, or $(Cu/Co)_n$, respectively, depending on which of the metal layers is deposited first. In one aspect, the laminate includes $NiFe/(laminate/NiFe)_n$. Here, the number n can be defined by the desired total thickness of the sense layer 23 and concentration of insertion within NiFe.

Typically, the Co or Co alloy layer in the laminates has a thickness between 0.05 nm and 0.5 nm while the Pd, Pt, Cu, or Au layer has a thickness from 0.2 nm to 1 nm.

Typically, as the number "n" of laminations increases, PMA within the laminated layer increases. However, the magnetoresistive (MR) ratio for a laminated layer such as $(Co/Ni)_n$ is generally less than observed for a CoFe or CoFeB layer. In the present magnetoresistive element 2, a TMR ratio equal or above than 100% can be obtained by including the interface layer 26.

In another embodiment, the enhancing material comprises an oxide insert 232 within the soft ferromagnetic material.

In one aspect, the oxide insert comprises one continuous layer 232 or a plurality of continuous layers 232 (see **Fig. 6).** The continuous layers 232 are within the first portion 231 comprising, or being made of, the soft ferromagnetic material.

The second portion 232 comprising the enhancing material has a thickness between 0.1 nm and 5 nm.

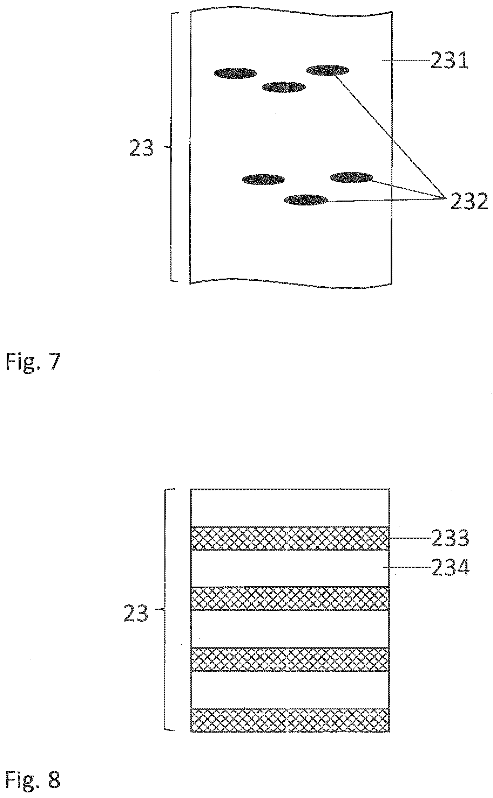

In another aspect illustrated in **Fig. 7,** the oxide insert comprises a plurality of clusters 232.

The oxidation state and thickness of the oxide insert layer, or the size of the oxide insert cluster, can be controlled to give a resistance-area (RA) product smaller than that of the oxide in the tunnel barrier layer 33 in order to minimize a decrease in the MR ratio of the magnetoresistive element 2.

Preferably, the oxide insert comprises MgO. However, other oxides may be considered, including SiOx, SrTiOx, BaTiOx, CaTiOx, LaAlOx, MnOx, VOx, AlOx, TiOx, MgTaOx, and HfOx.

In another embodiment shown in **Fig. 8,** the sense layer 23 comprises a laminated structure including one of

$(NiFe/Ni)_n$, $(Ni/Co)_n$ or $(NiFe/Co)_n$, where n is the number of the layers and n is between about 10 and 100. In Fig. 8, the laminated structure comprising the bilayers $(A/B)_n$ is indicated by the numerals 233 and 234, respectively (for example, layer A is 233 and layer B is 234).

One or more of the laminated layers may be a Co-based alloy such as CoFe or CoFeB as a replacement for Co, and a Ni-based alloy such as NiCo, NiFe, or NiFeB may be a replacement for Ni. Preferably, the Co-based alloy is Co rich wherein the Co content is >50 atomic %, and the Ni-based alloy is Ni rich wherein the Ni content is >50 atomic %. Thus, $(CoFe/Ni)_n$, $(CoFeB/Ni)_n$, $(Co/NiFe)_n$, $(Co/NiFeB)_n$, and $(NiCo/Co)_n$ are alternatives for sense layer 23.

In yet another embodiment, the ferromagnetic material comprises a Heusler alloy. The Heusler alloy allows for the sense layer 23 having a thickness between 5 nm and 20 nm to have a sense magnetization 230 ranging between 200 to 400 emu/$cm^3$ and such that the sense layer 23 has a perpendicular magnetic anisotropy field $H_{PMA}$ that is greater than 1 kOe (79.6x$10^3$ A/m).

In one aspect, the Heusler alloy can comprise a Mn containing alloy. For instance, the Heusler alloy can comprise a NiMnGa, CoMnGa, FeMnGa, CoFeSi, CoMnSi, NiMnSb, CoMnSb or a CoMnAl alloy.

In another aspect, the Heusler alloy can comprise comprises a $Co_2FeAl$, MnAs, MnSb, CoTb, $NdCo_5$, or a $SmCo_5$ alloy.

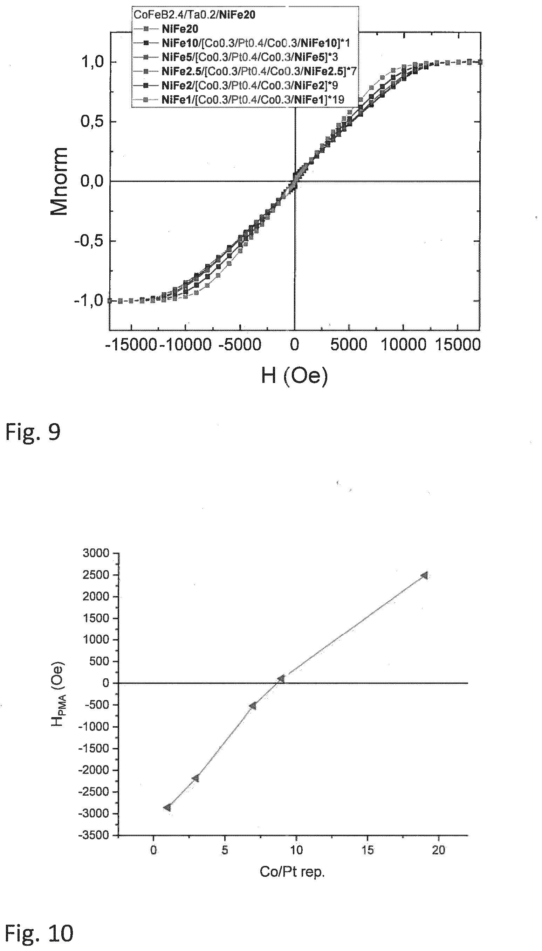

**Fig. 9** shows out-of-plane magnetization loops for several configuration of the sense layer 23 including the following laminated structures:

NiFe10 / [Co0.3 / Pt0.4 / Co0.3] / NiFe10, 1 time;

NiFe5 / [Co0.3 / Pt0.4 / Co0.3] / NiFe5, repeated 3 times;

NiFe2.5 / [Co0.3 / Pt0.4 / Co0.3] / NiFe2.5, repeated 7 times;

NiFe2 / [Co0.3 / Pt0.4 / Co0.3] / NiFe2, repeated 9 times; and

NiFe1 / [Co0.3 / Pt0.4 / Co0.3] / NiFe1, repeated 19 times.

The out-of-plane magnetization loop for the sense layer 23 comprising a pure NiFe layer of 20nm is also shown.

**Fig. 10** shows a fit of the out-of-plane magnetization loops of Fig. 9 using a using macrospin model in order to determine the perpendicular magnetic anisotropy field $H_{PMA}$. Fig. 10 shows that the perpendicular magnetic anisotropy field $H_{PMA}$ is positive for the laminated structures comprising 10 repetitions of Co0.3/Pt0.4/Co0.3 or more. Perpendicular magnetic anisotropy field $H_{PMA}$ values of a few kOe are strong enough to provide large out-of-plane sensitivities as shown on the simulations of Fig. 4, without requiring a thick sense layer 23 (for example, the thickness of the sense layer 23 can be below 100 nm).

Calculations have shown that the magnetoresistive element 2 with the sense layer 23 having a low magnetization and high perpendicular magnetic anisotropy field $H_{PMA}$, for example a perpendicular magnetic anisotropy field $H_{PMA}$ that is higher than about 1 kOe (79.6x$10^3$ A/m) or between 1 and 3 kOe (79.6x$10^3$ and 238.7 x$10^3$ A/m) allows obtaining high level of sensitivity S (for example an out-of-plane sensitivity S greater than 1 mV/V/mT), with the sense layer 23 being no thicker than 50 nm. The magnetoresistive element 2 is thus simpler to fabricate since there is no need in modifying the fabrication process as required when depositing a thick sense layer. It furthers allows to achieve more compact sensor layout.

Reference numbers and symbols

| | |
|---|---|
| 2,2a-2d | magnetoresistive element |
| 20 | magnetoresistive sensor |
| 21 | reference layer |
| 210 | reference magnetization |
| 211 | first reference layer, soft reference layer |
| 212 | coupling layer |
| 213 | second reference layer, hard reference layer |
| 22 | tunnel barrier layer |
| 23 | sense layer |
| 230 | sense magnetization |
| 231 | first portion |
| 232 | second portion, oxide insert |

| 233 | layer A |
| 234 | layer B |
| 24, 25 | capping layer |

| 26 | interface layer |
| 31 | measuring current |
| 60 | external magnetic field |

| $\chi$ | susceptibility |
| $H_{PMA}$ | perpendicular magnetic anisotropy field |
| S | sensitivity |
| $V_{out}$ | output voltage |

**Claims**

1. Magnetoresistive element, comprising

   a reference layer (21) having a reference magnetization (210) oriented out-of-plane;
   a sense layer (23) having a sense magnetization (230) comprising a vortex configuration stable under the presence of an external magnetic field (60), the sense magnetization (230) being reversibly movable in a direction out-of-plane relative to the reference magnetization (210) when the external magnetic field (60) varies in a direction out-of-plane; and
   a tunnel barrier layer (22) between the reference layer (21) and the sense layer (23);
   wherein
   the sense layer (23) has a thickness smaller than 200 nm;
   the sense layer (23) comprises a ferromagnetic material configured such that the sense magnetization (230) is between $300 \times 10^3$ and $1400 \times 10^3$ A/m and
   **characterized in that** said ferromagnetic material is further configured such that the sense layer (23) has a perpendicular magnetic anisotropy field ($H_{PMA}$) that is greater than $79.6 \times 10^3$ A/m.

2. The magnetoresistive element according to claim 1, wherein the sense layer (23) comprises a soft ferromagnetic material and an enhancing material configured to enhance the perpendicular magnetic anisotropy field ($H_{PMA}$).

3. The magnetoresistive element according to claim 2, wherein the soft ferromagnetic material comprises a NiFe, CoFe, or a CoFeB alloy.

4. The magnetoresistive element according to claim 2 or 3, wherein the enhancing material comprises a laminate including any one of: $(Co/Pt)_n$, $(Co/Pd)_n$, $(Co/Au)_n$, $(Co/Fe)n$, $(CoCr/Pt)_n$, $(NiFe/Cu)_n$, or $(Co/Cu)_n$, where n is the number of the multilayer and n is between about 10 and 100.

5. The magnetoresistive element according to claim 2 or 3, wherein the enhancing material comprises an oxide insert (232) within the soft ferromagnetic material.

6. The magnetoresistive element according to claim 5, wherein the oxide insert comprises one continuous layer (232) or a plurality of continuous layers (232).

7. The magnetoresistive element according to claim 5, wherein the oxide insert comprises a plurality of clusters (232).

8. The magnetoresistive element according to any one of claims 5 to 7,
   wherein the oxide insert comprises MgO.

9. The magnetoresistive element according to claim 4 or 6, wherein the enhancing material has a thickness between 0.1 nm and 2 nm.

10. The magnetoresistive element according to claim 1, wherein the sense layer (23) comprises a laminated structure including one of $(NiFe/Ni)_n$, $(Ni/Co)_n$ or $(NiFe/Co)_n$, where n is the number of the layers and n is between about 10 and 100.

11. The magnetoresistive element according to claim 1, wherein the ferromagnetic material comprises a Heusler alloy.

12. The magnetoresistive element according to claim 11, wherein the ferromagnetic material comprises a Mn containing alloy.

13. The magnetoresistive element according to claim 12, wherein the ferromagnetic material comprises a NiMnGa, CoMnGa, FeMnGa, CoFeSi, CoMnSi, NiMnSb, CoMnSb or a CoMnAl alloy.

14. The magnetoresistive element according to claim 11, wherein the ferromagnetic material comprises a $Co_2FeAl$, MnAs, MnSb, CoTb, $NdCo_5$, or a $SmCo_5$ alloy.

15. A magnetoresistive sensor comprising a plurality of the magnetoresistive element (2), according to any one of claims 1 to 15.

16. The magnetoresistive sensor according to claim 15, arranged in a Wheatstone circuit and comprising a out-of-plane sensitivity greater than 1 mV/V/mT.


**Patentansprüche**

1. Magnetoresistives Element, umfassend

   eine Referenzschicht (21) mit einer Referenzmagnetisierung (210), die außerhalb der Ebene ausgerichtet ist;
   eine Erfassungsschicht (23) mit einer Erfassungsmagnetisierung (230), die eine Wirbelkonfiguration umfasst, die unter dem Vorhandensein eines externen Magnetfelds (60) stabil ist, wobei die Erfassungsmagnetisierung (230) in einer Richtung außerhalb der Ebene relativ zu der Referenzmagnetisierung (210) reversibel bewegbar ist, wenn sich das externe Magnetfeld (60) in einer Richtung außerhalb der Ebene ändert; und
   eine Tunnelbarriereschicht (22) zwischen der Referenzschicht (21) und der Erfassungsschicht (23);
   wobei
   die Erfassungsschicht (23) eine Dicke von weniger als 200 nm aufweist;
   die Erfassungsschicht (23) ein ferromagnetisches Material umfasst, das so konfiguriert ist, dass die Erfassungsmagnetisierung (230) zwischen 300 x $10^3$ und 1400 x $10^3$ A/m liegt, und
   **dadurch gekennzeichnet, dass** das ferromagnetische Material ferner so konfiguriert ist, dass die Erfassungsschicht (23) ein senkrechtes magnetisches Anisotropiefeld ($H_{PMA}$) aufweist, das größer als 79,6 x $10^3$ A/m ist.

2. Magnetoresistives Element nach Anspruch 1,
   wobei die Erfassungsschicht (23) ein weiches ferromagnetisches Material und ein Verstärkungsmaterial umfasst, das dazu konfiguriert ist, das senkrechte magnetische Anisotropiefeld ($H_{PMA}$) zu verstärken.

3. Magnetoresistives Element nach Anspruch 2, wobei das weiche ferromagnetische Material eine NiFe-, CoFe- oder eine CoFeB-Legierung umfasst.

4. Magnetoresistives Element nach Anspruch 2 oder 3, wobei das Verstärkungsmaterial ein Laminat umfasst, das eines der Folgenden beinhaltet:
   $(Co/Pt)_n$, $(Co/Pd)_n$, $(Co/Au)_n$, (Co/Fe)n, $(CoCr/Pt)_n$, $(NiFe/Cu)_n$ oder $(Co/Cu)_n$, wobei n die Zahl der Mehrschicht ist und n zwischen etwa 10 und 100 liegt.

5. Magnetoresistives Element nach Anspruch 2 oder 3, wobei das Verstärkungsmaterial einen Oxideinsatz (232) innerhalb des weichen ferromagnetischen Materials umfasst.

6. Magnetoresistives Element nach Anspruch 5, wobei der Oxideinsatz eine durchgehende Schicht (232) oder eine Vielzahl von durchgehenden Schichten (232) umfasst.

7. Magnetoresistives Element nach Anspruch 5, wobei der Oxideinsatz eine Vielzahl von Clustern (232) umfasst.

8. Magnetoresistives Element nach einem der Ansprüche 5 bis 7, wobei der Oxideinsatz MgO umfasst.

9. Magnetoresistives Element nach Anspruch 4 oder 6, wobei das Verstärkungsmaterial eine Dicke zwischen 0,1 nm und 2 nm aufweist.

10. Magnetoresistives Element nach Anspruch 1, wobei die Erfassungsschicht (23) eine laminierte Struktur umfasst, die eines von $(NiFe/Ni)_n$, $(Ni/Co)_n$ oder $(NiFe/Co)_n$ beinhaltet, wobei n die Anzahl der Schichten ist und n zwischen etwa 10 und 100 liegt.

11. Magnetoresistives Element nach Anspruch 1, wobei das ferromagnetische Material eine Heusler-Legierung umfasst.

12. Magnetoresistives Element nach Anspruch 11, wobei das ferromagnetische Material eine Mn-haltige Legierung umfasst.

13. Magnetoresistives Element nach Anspruch 12, wobei das ferromagnetische Material eine NiMnGa-, CoMnGa-, FeMnGa-, CoFeSi-, CoMnSi-, NiMnSb-, CoMnSb- oder eine CoMnAl-Legierung umfasst.

14. Magnetoresistives Element nach Anspruch 11, wobei das ferromagnetische Material eine $Co_2FeAl$-, MnAs-, MnSb-, CoTb-, $NdCo_5$ - oder eine $SmCo_5$ -Legierung umfasst.

15. Magnetoresistiver Sensor, umfassend eine Vielzahl des magnetoresistiven Elements (2), nach einem der Ansprüche 1 bis 15.

16. Magnetoresistiver Sensor nach Anspruch 15, angeordnet in einer Wheatstone-Schaltung und umfassend eine Empfindlichkeit außerhalb der Ebene von mehr als 1 mV/V/mT.


**Revendications**

1. Elément magnétorésistif, comprenant

   une couche de référence (21) possédant une aimantation de référence (210) orientée hors plan ;
   une couche de détection (23) possédant une aimantation de détection (230) comprenant une configuration de vortex stable en présence d'un champ magnétique externe (60), l'aimantation de détection (230) étant mobile de manière réversible dans une direction hors plan par rapport à l'aimantation de référence (210) lorsque le champ magnétique externe (60) varie dans une direction hors plan ; et
   une couche barrière tunnel (22) entre la couche de référence (21) et la couche de détection (23) ;
   ladite couche de détection (23) possédant une épaisseur inférieure à 200 nm;
   ladite couche de détection (23) comprenant un matériau ferromagnétique conçu de sorte que l'aimantation de détection (230) soit comprise entre $300 \times 10^3$ et $1400 \times 10^3$ A/m et
   **caractérisé en ce que** ledit matériau ferromagnétique est en outre conçu de sorte que la couche de détection (23) possède un champ d'anisotropie magnétique perpendiculaire ($H_{PMA}$) qui est supérieur à $79,6 \times 10^3$ A/m.

2. Elément magnétorésistif selon la revendication 1,
   ladite couche de détection (23) comprenant un matériau ferromagnétique doux et un matériau d'amélioration conçu pour améliorer le champ d'anisotropie magnétique perpendiculaire (HPMA).

3. Elément magnétorésistif selon la revendication 2, ledit matériau ferromagnétique doux comprenant un alliage de NiFe, de CoFe ou de CoFeB.

4. Elément magnétorésistif selon la revendication 2 ou 3, ledit matériau d'amélioration comprenant un stratifié comprenant un quelconque parmi :
   $(Co/Pt)_n$, $(Co/Pd)_n$, $(Co/Au)_n$, $(Co/Fe)_n$, $(CoCr/Pt)_n$, $(NiFe/Cu)_n$, ou $(Co/Cu)_n$, où n est le numéro de la multicouche et n est compris entre environ 10 et 100.

5. Elément magnétorésistif selon la revendication 2 ou 3, ledit matériau d'amélioration comprenant un insert d'oxyde (232) à l'intérieur dudit matériau ferromagnétique doux.

6. Elément magnétorésistif selon la revendication 5, ledit insert d'oxyde comprenant une couche continue (232) ou une pluralité de couches continues (232).

**7.** Elément magnétorésistif selon la revendication 5, ledit insert d'oxyde comprenant une pluralité d'amas (232).

**8.** Elément magnétorésistif selon l'une quelconque des revendications 5 à 7, ledit insert d'oxyde comprenant du MgO.

**9.** Elément magnétorésistif selon la revendication 4 ou 6, ledit matériau d'amélioration possédant une épaisseur comprise entre 0,1 nm et 2 nm.

**10.** Elément magnétorésistif selon la revendication 1, ladite couche de détection (23) comprenant une structure stratifiée comprenant l'un de $(NiFe/Ni)_n$, de $(Ni/Co)_n$ ou de $(NiFe/Co)_n$, où n est le nombre de couches et n est compris entre environ 10 et 100.

**11.** Elément magnétorésistif selon la revendication 1, ledit matériau ferromagnétique comprenant un alliage de Heusler.

**12.** Elément magnétorésistif selon la revendication 11, ledit matériau ferromagnétique comprenant un alliage contenant du Mn.

**13.** Elément magnétorésistif selon la revendication 12, ledit matériau ferromagnétique comprenant un alliage de NiMnGa, de CoMnGa, de FeMnGa, de CoFeSi, de CoMnSi, de NiMnSb, de CoMnSb ou de CoMnAl.

**14.** Elément magnétorésistif selon la revendication 11, ledit matériau ferromagnétique comprenant un alliage de $Co_2FeAl$, de MnAs, de MnSb, de CoTb, de $NdCo_5$ ou de $SmCo_5$.

**15.** Capteur magnétorésistif comprenant une pluralité d'éléments magnétorésistifs (2), selon l'une quelconque des revendications 1 à 15.

**16.** Capteur magnétorésistif selon la revendication 15, agencé dans un circuit de Wheatstone et comprenant une sensibilité hors plan supérieure à 1 mV/V/mT.

Fig. 1

Fig. 2

Fig. 3

Fig. 4

Fig. 5

Fig. 6

Fig. 7

Fig. 8

Fig. 9

Fig. 10

**EP 4 198 541 B1**

**Patent documents cited in the description**

- EP 20315489
- EP 2320489 A1
- WO 2013180277 A
- EP 3862769 A